# EUROPEAN PATENT APPLICATION

(11) **EP 4 851 999 A1**
(43) Date of publication of application: **09.12.2026**
(21) Application number: 25226902.2
(22) Date of filing: 23.12.2025
(51) Int. Cl.: G11C 11/406, G11C 11/4078, G11C 11/4096

(54) **MEMORY FOR SAMPLING TARGET ROW AND METHOD OF OPERATING MEMORY**

(30) Priority: 04.06.2025 KR 20250072594
(71) Applicant: SK hynix Inc., Bubal-eub Icheon-si Gyeonggi-do 17336 (KR)
(72) Inventor: NOH, Jun Seok, 17336 Icheon-si, Gyeonggi-do (KR); JOO, No Geun, 17336 Icheon-si, Gyeonggi-do (KR)
(74) Representative: Isarpatent

(57) **Abstract**

A method of operating a memory includes sampling a first row that is an activation target using a random sampling scheme, and storing the sampled first row as a target row, counting a number of activations of the first row, and excluding the first row from a random sampling target until the number of activations of the first row reaches a threshold.

## Description

### BACKGROUND

### 1. Technical Field

Embodiments of the present disclosure relate to a memory.

### 2. Related Art

As the integration density of a memory increases, spacing between multiple word lines included in the memory decreases. As the spacing between the word lines decreases, a coupling effect between adjacent word lines increases.

Moreover, whenever data is input to or output from each memory cell, a word line toggles between an active state and inactive state. As described above, as the coupling effect between adjacent word lines increases, a phenomenon occurs in which data stored in memory cells connected to word lines adjacent to a frequently enabled word line becomes corrupted. This phenomenon is called row hammer, which is problematic because a phenomenon in which data in memory cells is corrupted before the memory cells are refreshed due to word line disturbance occurs.

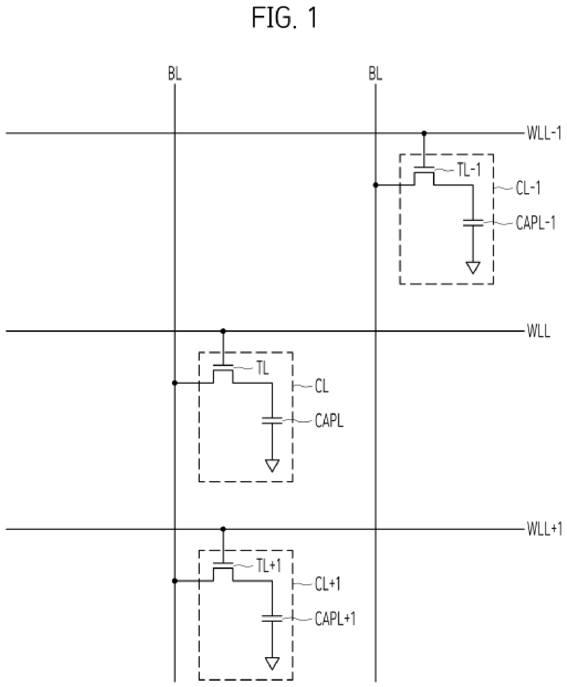

FIG. 1 is a diagram for describing row hammering and illustrates a portion of a cell array included in a memory.

In FIG. 1, 'WLL' corresponds to a word line which is frequently activated, and 'WLL-1' and 'WLL+1' correspond to word lines arranged adjacent to the word line 'WLL', that is, word lines adjacent to the frequently activated word line. Also, 'CL' represents a memory cell connected to the word line 'WLL', 'CL-1' represents a memory cell connected to the word line 'WLL-1' and 'CL+1' represents a memory cell connected to the word line 'WLL+1'. The memory cells include respective cell transistors TL, TL-1, and TL+1 and respective cell capacitors CAPL, CAPL-1, and CAPL+1.

In FIG. 1, when the word line 'WLL' is activated or deactivated, the voltages of the word lines 'WLL-1' and 'WLL+1' may rise or fall due to the coupling effect occurring between the word line 'WLL' and the word lines 'WLL-1' and 'WLL+1', thus influencing the charge amount of the cell capacitors CAPL-1 and CAPL+1. Therefore, when the activation of the word line 'WLL' frequently occurs, and then the word line 'WLL' toggles between active and inactive states, the change in amount of charge stored in the cell capacitors CAPL-1 and CAPL+1 included in the memory cells 'CL-1' and 'CL+1' may increase, and thus data in the memory cells may be degraded.

Also, electromagnetic waves, occurring as the word line toggles between the active state and the inactive state, cause electrons to flow into or out of the cell capacitors of the memory cells connected to the adjacent word lines, thus corrupting the stored data.

Methods for solving the row hammer that are mainly used, include methods for detecting a row (i.e., a word line) that is activated multiple times and refreshing rows neighboring the row activated multiple times.

### SUMMARY

In an embodiment of the present disclosure, a method of operating a memory may include sampling a first row that is an activation target using a random sampling scheme, and storing the sampled first row as a target row; counting a number of activations of the first row; and excluding the first row from a random sampling target until the number of activations of the first row reaches a threshold.

In an embodiment of the present disclosure, a memory may include a target row register circuit configured to randomly sample an activation target row and store a randomly sampled row as a target row; and a filter row register circuit configured to store one or more rows having a history of being selected as the target row as one or more filter rows, wherein the target row register circuit excludes rows identical to the filter rows from a random sampling target.

### BRIEF DESCRIPTION OF THE DRAWINGS

FIG. 1 is a diagram for describing row hammering and illustrates a portion of a cell array included in a memory.
FIG. 2 is a flowchart illustrating a process in which a target row is selected during an activation operation of a memory according to an embodiment of the present disclosure.
FIG. 3 is a flowchart illustrating a process in which a row hammer mitigation operation of a memory is performed according to an embodiment of the present disclosure.
FIG. 4 is a configuration diagram of a memory according to an embodiment of the present disclosure.
FIG. 5 is a configuration diagram illustrating an embodiment of a target row register circuit 420 of FIG. 4.
FIG. 6 is a configuration diagram illustrating an embodiment of a latch 431_0 and a valid signal generator 437_0 of a filter row register circuit 430 of FIG. 4.
FIG. 7 is a diagram illustrating a comparator 433_0 and a counter circuit 435_0 of the filter row register circuit 430 of FIG. 4.
FIG. 8 is a configuration diagram illustrating an embodiment of a register control circuit 440 of FIG. 4.

### DETAILED DESCRIPTION

Hereinafter, embodiments according to the technical spirit of the present disclosure are described with reference to the accompanying drawings.

Embodiments of the present disclosure relate to a technology for preventing a phenomenon in which the same rows are repeatedly refreshed during a row hammer mitigation operation.

To respond to data loss caused by row hammer, a scheme for identifying a row (word line) that is activated multiple times and refreshing rows adjacent to the identified row (hereinafter referred to as a 'target row') is used. To select the target row, a row which is repeatedly activated needs to be determined, and for this, a random sampling technique is utilized as a scheme that is operable within limited circuit resources.

The random sampling scheme is a technique for randomly selecting and sampling some activated rows, and exploits the fact that a frequently activated row has a higher probability of being sampled. However, because sampling is randomly performed in this scheme, there is a limitation in that a redundant operation in which the same row is successively selected as the target row and only rows adjacent to the target row are repeatedly refreshed may occur.

In an embodiment of the present disclosure, a target row register circuit and a filter row register circuit may be used to prevent the same row from being successively selected as the target row.

The target row register circuit is a circuit that stores a randomly sampled target row, that is, a row that is the target of a row hammer mitigation operation.

The filter row register circuit stores rows on which the row hammer mitigation operation is performed (i.e., rows having a history of being selected as the target row) as filter rows, and excludes rows belonging to the filter rows stored in this circuit from random sampling targets. In this disclosure, storing a row in a circuit means storing information, e.g., a row address indicating the row in the circuit and removing/excluding a row from a circuit or a row list means removing/excluding information, e.g., a row address indicating the row from the circuit or a row address list.

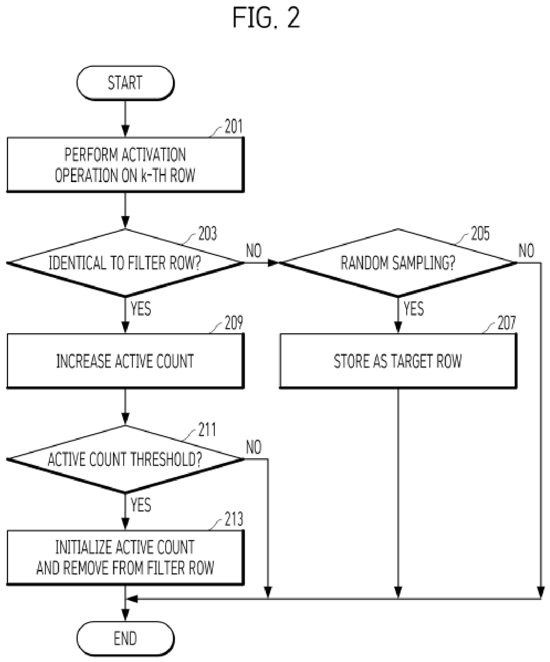

FIG. 2 is a flowchart illustrating a process in which a target row is selected during an activation operation of a memory according to an embodiment of the present disclosure.

Referring to FIG. 2, the activation operation may be performed on a k-th row in operation 201. The memory may receive a row address for designating the k-th row together with an activation command, and may perform an operation of activating the k-th row.

Whether the k-th row belongs to filter rows may be determined in operation 203. That is, it may be determined whether the k-th row is one of the filter rows stored in the filter row register circuit.

When the k-th row does not belong to the filter rows stored in the filter row register circuit (in the case of N in operation 203), the k-th row may become a candidate for random sampling in operation 205. When the k-th row is selected by random sampling (in the case of Y in operation 205), the k-th row may be stored as the target row in the target row register circuit in operation 207. When the k-th row is not selected by random sampling (in the case of N in operation 205), the k-th row may not be stored as a target row.

When the k-th row is one of the filter rows stored in the filter row register circuit (in the case of Y in operation 203), the active count of the k-th row as one of the filter rows may be increased by 1 in operation 209. The filter row register circuit stores respective active counts of the stored filter rows, wherein the active count of the k-th row as one of the filter rows is increased by 1.

Whether the active count has reached a threshold may be determined in operation 211. When it is determined that the active count has reached the threshold (in the case of Y in operation 211), the active count of the k-th row as the corresponding filter row may be initialized, and the k-th row as the corresponding filter row may be removed from the filter rows in operation 213. For example, when the active count of the k-th row has reached the threshold, the k-th row may no longer be a filter row. That is, the k-th row may become a candidate for random sampling again. When the active count does not reach the threshold (in the case of N in operation 211), the k-th row as the corresponding row may remain as the filter row.

As a result, as illustrated in FIG. 2, the memory may classify, as the filter row, a row selected as the target row, and the row may be excluded from the random sampling target. Therefore, a redundant operation in which the same row is repeatedly selected as the target row may be prevented. Furthermore, even when the row is classified as a filter row, the filter row may become a sampling target again when the filter row is activated a predetermined number of times, thus ensuring both sampling efficiency and target diversity.

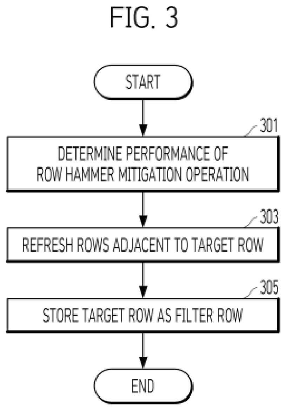

FIG. 3 is a flowchart illustrating a process in which a row hammer mitigation operation of a memory is performed according to an embodiment of the present disclosure.

Referring to FIG. 3, the performance of the row hammer mitigation operation may be determined in operation 301. The row hammer mitigation operation may be performed in response to a refresh command. For example, when the refresh command is applied ten times to the memory, the memory may perform a normal refresh operation nine times among the ten times, and may perform the row hammer mitigation operation of refreshing rows adjacent to the target row once. Also, the row hammer mitigation operation may be performed in response to a refresh management (RFM) command. The refresh management command may be a command indicating the row hammer mitigation operation.

The row hammer mitigation operation of refreshing the rows adjacent to the target row, stored in the target row register circuit, may be performed in operation 303. Adjacent rows to a target row may be refreshed. The range of adjacent rows of the target row, which are to be refreshed through the row hammer mitigation operation, may vary according to an embodiment.

The target row may be stored as a filter row in the filter row register circuit in operation 305. The filter row register circuit may include a plurality of latches in which filter rows are stored. The target row may be stored as the filter row in a latch storing the least recently updated filter row among the latches.

After the refresh operation is performed on the rows adjacent to the target row through the operation such as that illustrated in FIG. 3, the target row may be classified as the filter row and then stored in the filter row register circuit.

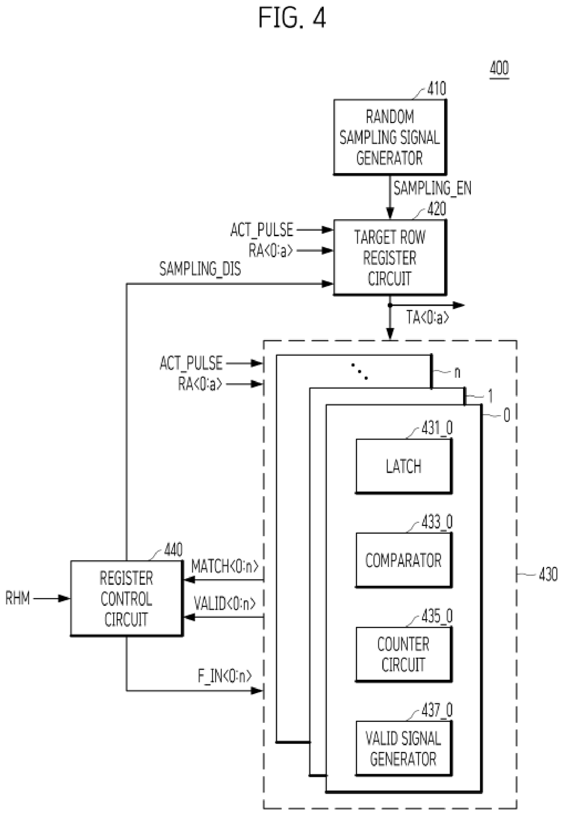

FIG. 4 is a configuration diagram of a memory according to an embodiment of the present disclosure. In FIG. 4, components related to sampling of a target row in the memory, that is, components related to the operations of FIGS. 2 and 3, are illustrated.

Referring to FIG. 4, a memory 400 may include a random sampling signal generator 410, a target row register circuit 420, a filter row register circuit 430, and a register control circuit 440.

The random sampling signal generator 410 may generate a random sampling signal SAMPLING_EN that is randomly enabled.

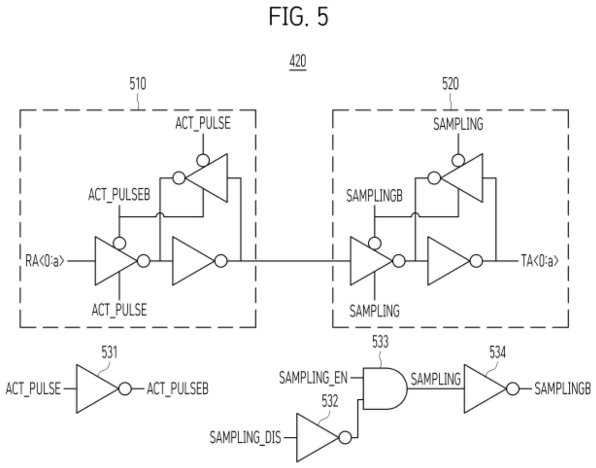

The target row register circuit 420 may randomly sample an activation target row and then store the randomly sampled row as a target row. The target row register circuit 420 may receive an active signal ACT_PULSE that is enabled during an activation operation, a row address RA<0:a> indicating the activation target row, the random sampling signal SAMPLING_EN, and a sampling prevention signal SAMPLING_DIS. A target row address TA<0:a> output from the target row register circuit 420 may be an address corresponding to the target row. The target row register circuit 420 may sample the row address RA<0:a> in response to the random sampling signal SAMPLING_EN and store the sampled row address as the target row address TA<0:a>. When the sampling prevention signal SAMPLING_DIS is enabled, the sampling operation may be disabled. The target row address TA<0:a> may be an address used in the row hammer mitigation operation of the memory 400, and rows adjacent to the target row designated by the target row address TA<0:a> may be refreshed during the row hammer mitigation operation. The target row register circuit 420 will be described in detail later with reference to FIG. 5.

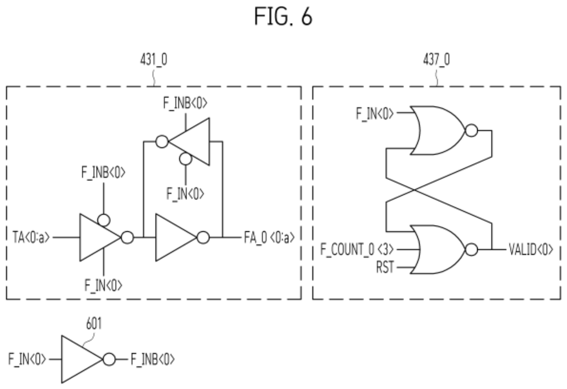

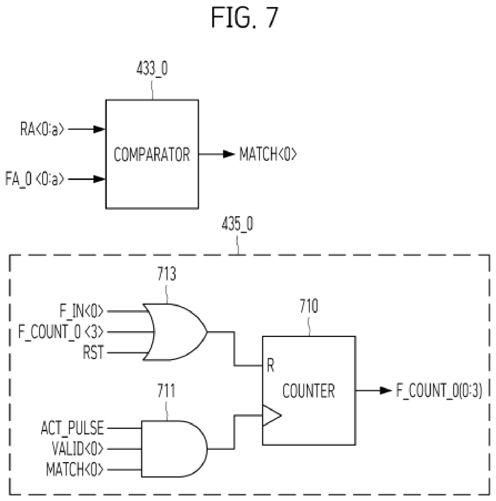

The filter row register circuit 430 may include a latch 431_0, a comparator 433_0, a counter circuit 435_0, and a valid signal generator 437_0. The filter row register circuit 430 may include multiple instances of each of the components 431_0, 433_0, 435_0, and 437_0. The filter row register circuit 430 may store a plurality of filter rows, and may include as many components 431_0, 433_0, 435_0, and 437_0 as the number of filter rows stored in the filter row register circuit 430. Here, an embodiment in which the filter row register circuit 430 stores n+1 filter rows and n+1 instances for each of the components are provided is illustrated. The latch 431_0 is a component that stores the filter rows, and the comparator 433_0 is a component that performs comparison as to whether the activation target row RA<0:a> is one of the filter rows. The counter circuit 435_0 is a component that counts the number of activations of each filter row after the corresponding filter row is stored in the latch 431_0, and the valid signal generator 437_0 is a component that generates a valid signal indicating whether the corresponding filter row stored in the latch 431_0 is valid. The components 431_0, 433_0, 435_0, and 437_0 will be described in detail later with reference to FIGS. 6 and 7.

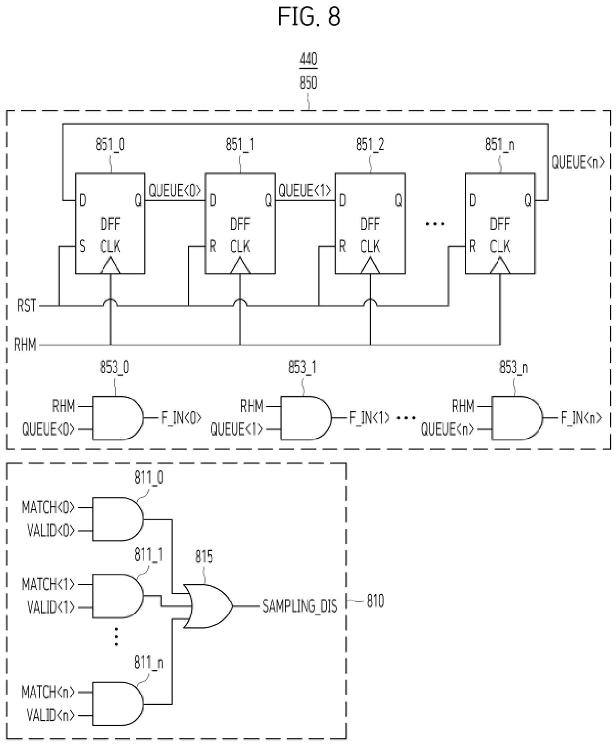

The register control circuit 440 may enable the sampling prevention signal SAMPLING_DIS when the activation target row is one of the filter rows. Also, the register control circuit 440 may generate latch selection signals F_IN<0:n> for selecting a latch in which the target row address TA<0:a> is to be stored from among the latches 431_0 to 431_n of the filter row register circuit 430. The register control circuit 440 will be described in detail later with reference to FIG. 8.

FIG. 5 is a configuration diagram illustrating an embodiment of the target row register circuit 420 of FIG. 4.

Referring to FIG. 5, the target row register circuit 420 may include two latches 510 and 520 connected in series to each other. Also, the target row register circuit 420 may include logic gates 531 to 534 that generate signals ACT_PULSEB, SAMPLING, and SAMPLINGB for controlling the latches 510 and 520.

The inverter 531 may invert the active signal ACT_PULSE to generate an inverted active signal ACT_PULSEB. The inverter 532 and the AND gate 533 may generate a sampling signal SAMPLING that is enabled to 1 when the random sampling signal SAMPLING_EN is enabled to 1 and the sampling prevention signal SAMPLING_DIS is disabled to 0. Also, the inverter 534 may invert the sampling signal SAMPLING to generate an inverted sampling signal SAMPLINGB.

When the active signal ACT_PULSE is enabled to 1, the latch 510 may receive the row address RA<0:a>, whereas when the active signal ACT_PULSE is disabled to 0, the latch 510 may maintain the value of the received address. The latch 510 may be configured to store the row address RA<0:a> having a+1 bits. That is, although a configuration in which the latch 510 includes two tri-state inverters and one inverter is illustrated in the drawing, the actual latch 510 may include a+1 instances for each of the components illustrated in the drawing.

When the sampling signal SAMPLING is enabled to 1, the latch 520 may receive the address stored in the latch 510, whereas when the sampling signal SAMPLING is disabled to 0, the latch 520 may maintain the value of the received address. The address stored in the latch 520 may be the target row address TA<0:a>. Consequently, when the sampling prevention signal SAMPLING_DIS is disabled and the random sampling signal SAMPLING_EN is enabled, the sampled row address RA<0:a> may be the target row address TA<0:a>. The latch 520 may be configured to store the target row address TA<0:a> having a+1 bits. That is, although a configuration in which the latch 520 includes two tri-state inverters and one inverter is illustrated in the drawing, the actual latch 520 may include a+1 instances for each of the components illustrated in the drawing.

FIG. 6 is a configuration diagram illustrating an embodiment of the latch 431_0 and the valid signal generator 437_0 of the filter row register circuit 430 of FIG. 4.

Referring to FIG. 6, an inverter 601 may invert a latch selection signal F_IN<0> to generate an inverted latch selection signal F_ INB<0>.

When the latch selection signal F_IN<0> is enabled to 1, the latch 431_0 may receive the target row address TA<0:a>, whereas when the latch selection signal F_IN<0> is disabled to 0, the latch 431_0 may maintain the value of the received address. The address stored in the latch 431_0 may be a filter row address FA_0<0:a>. The latch 431_0 may be configured to store the filter row address FA_0<0:a> having a+1 bits. That is, although a configuration in which the latch 431_0 includes two tri-state inverters and one inverter is illustrated in the drawing, the actual latch 431_0 may include a+1 instances for each of the components illustrated in the drawing.

The valid signal generator 437_0 may include an SR latch. When the latch selection signal F_IN<0> is enabled to 1, a valid signal VALID<0> may be enabled to 1. Also, when a count bit F_COUNT_0<3> becomes 1 or when a reset signal RST is enabled to 1, the valid signal VALID<0> may be disabled to 0. Here, the count bit F_COUNT_0<3> denotes the most significant bit of a 4-digit count code F_COUNT_0<0:3> obtained by counting the number of activations of the filter row stored in the latch 431_0. The case where the count bit F_COUNT_0<3> becomes to have the binary value 1 may mean that the number of activations of the filter row, stored in the latch 431_0, has reached a threshold of the decimal number 8. The threshold of the filter row may vary according to an embodiment, wherein the count code may be extended to 4 or more bits, and the count bit to be used to control the SR latch may also vary according to an embodiment. The reset signal RST may be a reset signal for resetting the memory 400. A valid signal VALID<0> of 1 may mean that a valid filter row is stored in the latch 431_0, and a valid signal VALID<0> of 0 may mean that the filter row stored in the latch 431_0 is not valid (i.e., the stored filter row is excluded from filter rows).

FIG. 7 is a diagram illustrating the comparator 433_0 and the counter circuit 435_0 of the filter row register circuit 430 of FIG. 4.

The comparator 433_0 may compare the row address RA<0:a> with the filter row address FA_0<0:a>, may activate a match signal MATCH<0> to 1 when the two addresses are identical to each other, and may disable the match signal MATCH<0> to 0 when the two addresses are different from each other.

The counter circuit 435_0 may include a counter 710, an AND gate 711, and an OR gate 713. The counter 710 may increase the value of a count code F_COUNT_0<0:3> when the output of the AND gate 711 is 1. That is, when an active signal ACT_PULSE, a valid signal VALID<0>, and the match signal MATCH<0> are all enabled to 1, the value of the count code F_COUNT_0<0:3> may be increased. This means that the value of the count code F_COUNT_0<0:3> increases when the activation operation is performed, the row address RA<0:a> is identical to the filter row address FA_0<0:a>, and the filter row address FA_0<0:a> is valid.

The value of the count code F_COUNT_0<0:3> generated by the counter 710 may be initialized to (0, 0, 0, 0) when the output of the OR gate 713 is 1. When the latch selection signal F_IN<0> is enabled to 1, that is, when the filter row address FA_0<0:a> is newly updated, the value of the count code F_COUNT_0<0:3> may be initialized. Further, when the count bit F_COUNT_0<3> is 1, that is, when the active count of the filter row reaches a threshold of 8, the value of the count code F_COUNT_0<0:3> may be initialized. Furthermore, when the reset signal RST is 1, the value of the count code F_COUNT_0<0:3> may be initialized.

FIG. 8 is a configuration diagram illustrating an embodiment of the register control circuit 440 of FIG. 4.

Referring to FIG. 8, the register control circuit 440 may include a sampling prevention signal generator 810 and a latch selection signal generator 850.

The sampling prevention signal generator 810 may include AND gates 811_0 to 811_n and an OR gate 815.

The AND gates 811_0 to 811_n output 1 when corresponding matching signals MATCH<0> to MATCH<n> and valid signals VALID<0> to VALID<n> corresponding thereto are 1. Also, the OR gate 815 may output a sampling prevention signal SAMPLING_DIS of 1 when the outputs of one or more of the AND gates 811_0 to 811_n are 1. That is, when the row address RA<0:a> is one of the filter row addresses FA_0<0:a> to FA_n<0:a>, and the filter row address is valid, the sampling prevention signal SAMPLING_DIS may be enabled to 1.

The latch selection signal generator 850 may include D flip-flops 851_0 to 85 1_n connected in series to each other in a ring shape, and AND gates 853_0 to 853_n.

The D flip-flops 851_0 to 851_n may initialize signals stored therein in response to a reset signal RST, wherein only one (e.g., 851_0) of the D flop-flops 851_0 to 851_n may be initialized to 1, and the remaining D flip-flops 851_1 to 851_n may be initialized to 0. The signal stored in each of the D flip-flops 851_0 to 851_n may be shifted whenever a row hammer mitigation signal RHM is enabled. The row hammer mitigation signal RHM may be a signal that is enabled whenever a row hammer mitigation operation is performed. Whenever the row hammer mitigation signal RHM is enabled, a signal to be enabled to 1, among the output signals QUEUE<0:n> of the D flip-flops 851_0 to 851_n, may be changed.

The AND gates 853_0 to 853_n may activate the latch selection signals F_IN<0:n> when the output signals QUEUE<0:n> of the D flip-flops 851_0 to 851_n and the row hammer mitigation signal RHM are enabled. For example, when the output signal QUEUE<1> of the D flip-flop 851_1 and the row hammer mitigation signal RHM are enabled, the latch selection signal F_IN<1> may be enabled.

Whenever the row hammer mitigation signal RHM is enabled, the latch selection signal generator 850 may sequentially activate one of the latch selection signals F_IN<0:n>, and then enable the target row address TA<0:a> to be stored in one of the latches 431_0 to 431_n of the filter row register circuit 430.

According to embodiments of the present disclosure, a phenomenon in which the same rows are repeatedly refreshed during a row hammer mitigation operation may be prevented.

Although the embodiments according to the technical spirit of the present disclosure have been described with reference to the accompanying drawings, these are provided to merely describe embodiments conforming to the concept of the present disclosure, and the present disclosure is not limited to those embodiments. It is apparent that various types of substitutions, modifications, and changes to embodiments may be made by those skilled in the art to which the present disclosure pertains without departing from the technical spirit of the present disclosure described in the accompanying claims, and such variations fall within the scope of the present disclosure. Furthermore, the embodiments may be combined to form additional embodiments.

## Claims

1. A method of operating a memory, the method comprising:
sampling a first row that is an activation target using a random sampling scheme, and storing the sampled first row as a target row;
counting a number of activations of the first row; and
excluding the first row from a random sampling target until the number of activations of the first row reaches a threshold.

2. The method of claim 1, wherein the excluding of the first row from the random sampling target comprises:
comparing a second row that is an activation target with the first row; and
when the second row is identical to the first row, preventing the second row from being stored as the target row.

3. The method of claim 1, further comprising refreshing a row adjacent to the target row during a row hammer mitigation operation.

4. The method of claim 3, further comprising performing the row hammer mitigation operation in response to one of a refresh command and a refresh management command.

5. A memory comprising:
a target row register circuit configured to randomly sample an activation target row and store a randomly sampled row as a target row; and
a filter row register circuit configured to store one or more rows having a history of being selected as the target row as one or more filter rows,
wherein the target row register circuit excludes rows identical to the filter rows from a random sampling target.

6. The memory of claim 5, wherein, among the filter rows, a row, a number of activations of which is equal to or greater than a threshold after the row is stored in the filter row register circuit, is excluded from the filter rows.

7. The memory of claim 5, wherein a row adjacent to the target row is refreshed during a row hammer mitigation operation.

8. The memory of claim 7, wherein the row hammer mitigation operation is performed in response to one of a refresh command and a refresh management command.

9. The memory of claim 5, wherein the target row register circuit comprises:
a first latch configured to store an activation target row in response to an active signal;
a second latch configured to store a row stored in the first latch as the target row in response to a sampling signal; and
a sampling signal generator configured to enable the sampling signal when a random sampling signal that is randomly enabled is enabled and a sampling prevention signal is disabled.

10. The memory of claim 9, wherein the filter row register circuit comprises:
a plurality of third latches configured to store the filter rows;
a plurality of comparators configured to compare filter rows stored in the plurality of third latches with the activation target row and then generate match signals;
a plurality of counter circuits configured to count numbers of activations of the respective filter rows; and
a plurality of valid signal generators configured to generate valid signals respectively corresponding to the filter rows and to disable a valid signal corresponding to a filter row, the number of activations of which has reached a threshold among the filter rows.

11. The memory of claim 10, further comprising:
a register control circuit configured to enable the sampling prevention signal when one or more of the match signals are enabled and valid signals corresponding to the enabled match signals are enabled.

12. The memory of claim 11, wherein the register control circuit selects a third latch, in which the filter row is to be updated from among the plurality of third latches.

13. The memory of claim 12, wherein the register control circuit selects a third latch in which the filter row was updated a longest time ago from among the plurality of third latches, as the third latch in which the filter row is to be updated.

14. The memory of claim 12, wherein a valid signal corresponding to the third latch in which the filter row is updated is enabled.

15. The memory of claim 9, further comprising:
a random sampling signal generator configured to generate the random sampling signal.
